# EUROPEAN PATENT APPLICATION

(11) **EP 4 269 419 A1**
(43) Date of publication of application: **01.11.2023**
(21) Application number: 21915212.1
(22) Date of filing: 23.12.2021
(51) Int. Cl.: C07F 7/18, B32B 15/08, B32B 15/082, B32B 15/20, B32B 27/00, B32B 27/30, C09D 5/00, C09D 7/63, H05K 3/38

(54) **COMPOUND, BONDING AGENT, JOINED BODY, PRINTED SUBSTRATE, AND METHOD FOR MANUFACTURING BONDED BODY**

(30) Priority: 28.12.2020 JP 2020219696
(71) Applicant: Daicel Corporation, Osaka 530-0011 (JP); Sulfur Chemical Laboratory Inc., Morioka-shi, Iwate 020-0066 (JP)
(72) Inventor: HAPPOYA, Akihiko, Tokyo 108-8230 (JP); ISHIKAWA, Shinsuke, Tokyo 108-8230 (JP); MORI, Katsuhito, Morioka-shi, Iwate 020-0066 (JP)
(74) Representative: Grünecker Patent- und Rechtsanwälte PartG mbB
(86) International application number: PCT/JP2021/048015
(87) International publication number: WO 2022/145352

(57) **Abstract**

[Object] To provide a compound and the like that are capable of increasing bonding strength.

[Solving Means] The present disclosure relates to a compound and the like having, in one molecule: at least one type of functional group selected from the group consisting of an OH group and an OH-generating group; an organic group including a carbon-carbon double bond; and a triazine ring. Selected Drawing: None

## Description

### Technical Field

The present disclosure relates to a compound, a bonding agent, a bonded body, printed circuit board, and a method for manufacturing a bonded body.

### Background Art

In a related art, a bonding agent containing a compound of the following chemical formula (1) is used for bonding different materials (for example, Patent Document 1);

X-Y-Si-(CH₃)ₐ(OR)₃₋ₐ ... (1)

in the chemical formula (1), X is an unsaturated group containing an alkenyl group; Y is any spacer group selected from the group consisting of - (CH₂)ₙ₁-, -(C₆H₄)-, -(C₆H₄)CH₂-, -NH-C₆H₄-, -NH-C₆H₄CH₂-, and -NH-(CH₂)ₙ₂-, where n1 to n2 are numbers from 1 to 12; R is a methyl, ethyl, propyl, isopropyl, or butyl group, and a is a number from 0 to 2.

### Citation List

### Patent Document

Patent Document 1: WO 2012/077676

### Summary of Invention

### Technical Problem

In the future, bonding agents or compounds capable of further increasing bonding strength may be required, but such a bonding agent or compound has not been fully studied.

Accordingly, an object of the present disclosure is to provide a compound capable of increasing bonding strength, a bonding agent capable of increasing bonding strength, a bonded body formed from the bonding agent, a printed circuit board including the bonded body, and a method for manufacturing a bonded body using the bonding agent.

### Solution to Problem

The first of the present disclosure relates to a compound having, in one molecule: at least one type of functional group selected from the group consisting of an OH group and an OH-generating group; an organic group including a carbon-carbon double bond; and a triazine ring.

Preferably, the compound has an alkoxysilyl group as the OH-generating group.

Preferably, the compound is represented by the following general formula (1):

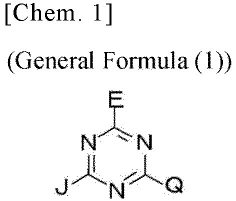

In the general formula (1),
J is an organic group including a carbon-carbon double bond,
E is a group including an OH group or an OH-generating group,
Q is an organic group including a carbon-carbon double bond, which is identical to or different from J, or NR₁(R₂),
the R₁ and the R₂ are each H, a hydrocarbon group having from 1 to 24 carbons, or -RSi(R')ₙ₁(OR")₃₋ₙ₁, which may be identical or different,
the R is a linear divalent hydrocarbon group having from 1 to 12 carbons,
the R' is a linear hydrocarbon group having from 1 to 4 carbon atoms,
the R" is H or a linear hydrocarbon group having from 1 to 4 carbons, and
the n1 is an integer from 0 to 2.

Preferably, E in the general formula (1) is the NR₁(R₂).

Preferably, Q in the general formula (1) is the J.

Preferably, Q in the general formula (1) is the NR₁(R₂).

Preferably, the compound has at least one type of the following functional groups, as the organic group including the carbon-carbon double bond:

CH₂ = CHNH-,

CH₂ = CH(CH₂)NH-,

CH₂ = CH(CH₂)ₙ₂NH - (n2 = from 2 to 16),

CH₂ = CHCH₂(N-)CH₂CH = CH₂,

CH₂ = C(CH₃)CH₂NH-,

CH₂ = CHCH₂(N-)C(CH₃)₃,

CH₂ = CHC₆H₄NH-,

CH₂ = CHC₆H₄CH₂NH-,

CH₂ = C(CH₃)(C = O)NH-,

CH₂ = CHCH₂NH(C = O)NH-,

C₆H₅(N-)CH₂CH = CH₂,

-NH(NH₂)C₃N₃CH = CH₂,

CH₂ = CHO-,

CH₂ = CH(CH₂)O-,

CH₂ = CH(CH₂)ₙ₃O-(n3 = from 2 to 16),

CH₂ = C(CH₃)CH₂O-,

CH₂ = CHC₆H₄O-,

CH₂ = CHC₆H₄CH₂O-,

CH₂ = CH-O(CH₂)ₙ₄O-(n4 = from 1 to 16),

CH₂ = CH-O(CH₂)₂O-(CH₂)₂O-,

CH₂ = CHS-,

CH₂ = CH(CH₂)S-,

CH₂ = CH(CH₂)ₙ₅S-(n5 = from 2 to 16),

CH₂ = C(CH₃)CH₂S-,

CH₂ = CHC₆H₄S-,

CH₂ = CHC₆H₄CH₂S-,

(CH₂ = CHCH₂NCH₂CH = CH₂)₂C₃N₃S-,

(CH₂ = CHCH₂NH)₂C₃N₃S-,

(CH₂ = CHCH₂NCH₂CH = CH₂)C₃N₃(SH)S-,

(CH₂ = CHCH₂NH)C₃N₃(SH)S-,

CH₂ = CHCOO-(CH₂)ₙ₇-S-(n7 = from 1 to 16),

CH₂ = C(CH₃)COO-(CH₂)ₙ₈-S-(n8 = from 1 to 16),

CH₂ = CH-,

CH₂ = CH(CH₂)-,

CH₂ = CH(CH₂)ₙ₆-(n6 = from 2 to 16),

CH₂ = C(CH₃)CH₂-,

CH₂ = CHC₆H₄-,

or

CH₂ = CHC₆H₄CH₂-.

The second of the present disclosure relates to a bonding agent containing the compound (α).

Preferably, the bonding agent is used for bonding a material A and a polymer material B.

Preferably, the material A is a metal material.

The third of the present disclosure relates to a bonded body formed by bonding the material A and the polymer material B with the bonding agent.

The fourth of the present disclosure relates to a printed circuit board including the bonded body.

The fifth of the present disclosure relates to a method for manufacturing a bonded body formed by bonding, with a bonding agent, a base A with a material A at a surface A and a base B with a polymer material B at a surface B, the method includes:
(X) providing the bonding agent on the surface A;
(Y) bringing the base A and the base B to abut each other such that the surface A and the surface B are brought into contact with the bonding agent interposed between the surface A and the surface B; and
(Z) applying a pressure to the contact surface between the surface A and the surface B with the bonding agent interposed between the surface A and the surface B to form the bonded body.

Preferably, the method for manufacturing a bonded body further includes, before the (X), (A) producing an OH group at the surface A, the producing including subjecting the surface A to one or more treatments selected from the group consisting of a degreasing treatment, a corona discharge treatment, a plasma discharge treatment, ultraviolet irradiation, an acid treatment, an alkali treatment, a water vapor treatment, and a chemical conversion treatment.

Preferably, the method for manufacturing a bonded body includes, after the (X), heating the surface A and the bonding agent to chemically bond the OH group at the surface A and at least one type of functional group selected from the group consisting of an OH group and an OH-generating group of the compound (α) by dehydration condensation.

Preferably, in the method for manufacturing a bonded body, in the (X), the bonding agent is provided on the surface A by immersing the surface A in the bonding agent, by spraying the bonding agent onto the surface A, or by applying the bonding agent to the surface A with a coating device.

Preferably, in the method for manufacturing a bonded body, in the (Z), a pressure is applied to the contact surface between the surface A and the surface B with the bonding agent interposed between the surface A and the surface B such that the polymer material B and the adhesive are brought into contact with each other.

Preferably, in the method for manufacturing a bonded body, the pressure is applied in the (Z) under a temperature condition from 0 to 350°C.

Preferably, in the method for manufacturing a bonded body, in the (Z), the pressure is applied to the contact surface while the contact surface is headed.

The sixth of the present disclosure relates to a method for manufacturing a bonded body formed by bonding a metal material and a polymer material B with a bonding agent, the method includes:
using the bonding agent, the bonding agent having an alkoxysilyl group as the OH-generating group;
providing the bonding agent on a surface B of a base B, the base B having the polymer material B at the surface B, and having the triazine ring and the alkoxysilyl group to be present at the surface B; and
forming the bonded body by providing an electroless plating solution on the triazine ring and the alkoxysilyl group of the surface B.

The seventh of the present disclosure relates to a bonding agent for use in bonding a metal material and a polymer material B, where a peel strength is 5 N/cm or greater in peeling off at a speed of 50 mm/min in accordance with the method of JIS K6854-1: 1999 "Adhesives-Determination of peel strength of bonded assemblies- Part 1: 90° peel".

Preferably, the bonding agent has a peel strength of 5 N/cm or greater after a solder reflow test at 260°C.

Preferably, the bonding agent is used for bonding a copper foil including copper as the metal material.

Preferably, a bonding surface of the copper foil has surface roughness (Rz) from 0.5 to 1.5 µm.

Preferably, a bonding surface of the copper foil has surface roughness (Rz) from 0.5 to 1.0 µm.

Preferably, a bonding surface of the copper foil has surface roughness (Rz) of 0.8 µm.

Preferably, the bonding agent contains a compound (α) represented by the following general formula (1).

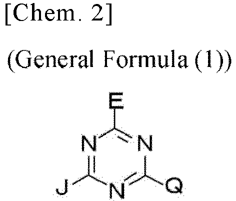

In the general formula (1),
J is an organic group including a carbon-carbon double bond,
E is a group including an OH group or an OH-generating group,
Q is an organic group including a carbon-carbon double bond, which is identical to or different from J, or NR₁(R₂),
the R₁ and the R₂ are each H, a hydrocarbon group having from 1 to 24 carbons, or -RSi(R')ₙ₁(OR")₃₋ₙ₁, which may be identical or different,
the R is a linear divalent hydrocarbon group having from 1 to 12 carbons,
the R' is a linear hydrocarbon group having from 1 to 4 carbon atoms,
the R" is H or a linear hydrocarbon group having from 1 to 4 carbons, and
the n1 is an integer from 0 to 2.

The eighth of the present disclosure is a bonded body formed by bonding a metal material and the polymer material B with the bonding agent, where a peel strength is 5 N/cm or greater in peeling off the metal material or the polymer material at a speed of 50 mm/min in accordance with the method of JIS K6854-1: 1999 "Adhesives-Determination of peel strength of bonded assemblies- Part 1: 90° peel".

Preferably, the bonded body has the peel strength of 5 N/cm or greater after a solder reflow test at 260°C.

Preferably, the bonded body is formed by bonding a copper foil including the copper material as the metal material.

Preferably, a bonding surface of the copper foil has surface roughness (Rz) from 0.5 to 1.5 µm.

Preferably, a bonding surface of the copper foil has surface roughness (Rz) from 0.5 to 1.0 µm.

Preferably, a bonding surface of the copper foil has surface roughness (Rz) of 0.8 µm.

The ninth of the present disclosure relates to a printed circuit board including the bonded body.

### Advantageous Effects of Invention

According to the present disclosure, the bonding strength can be increased.

### Description of Embodiments

Hereinafter, an embodiment of the present disclosure will be described.

Note that each of the configurations, combinations thereof, and the like in each embodiment are an example, and various additions, omissions, substitutions, and other changes may be made as appropriate without departing from the spirit of the present disclosure. The present disclosure is not limited by the embodiments and is limited only by the claims.

Also, each aspect disclosed in the present specification can be combined with any other feature disclosed herein.

### <Present Embodiment>

The compound according to the present embodiment is a compound (α) having, in one molecule: at least one type of functional group selected from the group consisting of an OH group and an OH-generating group; an organic group including a carbon-carbon double bond; and a triazine ring.

Examples of the triazine of the triazine ring include 1,3,5-triazine.

The compound (α) preferably has an alkoxysilyl group as the OH-generating group.

The alkoxysilyl group is preferably -RSi(R')ₙ₁(OR")₃₋ₙ₁.

Note that the R is a linear divalent hydrocarbon group having from 1 to 12 carbons, the R' is a linear hydrocarbon group having from 1 to 4 carbon atoms, the R" is H or a linear hydrocarbon group having from 1 to 4 carbons, and the n1 is an integer from 0 to 2.

Note that, in the present embodiment, the "hydrocarbon group" and the "hydrocarbon" may each have a group such as -NH-, -CO-, -O-, -S-, and - COO-.

In addition, each of the "hydrocarbon group" and the "hydrocarbon" may be a linear hydrocarbon group or a cyclic group.

Furthermore, the "hydrocarbon group" and the "hydrocarbon" may each have a substituent group (cyclic or linear).

The number of the carbon atoms of the R is preferably from 1 to 18, more preferably from 1 to 12.

Examples of the R include -CₙH₂ₙ.

Examples of the R' include -CₙH₂ₙ₊₁.

In a case where the R" is a hydrocarbon group, examples of the R" include -CH₃, -C₂H₅, -CH(CH₃)₂, and -C(CH₃)₃.

In addition, the compound (α) is preferably represented by the following general formula (1).

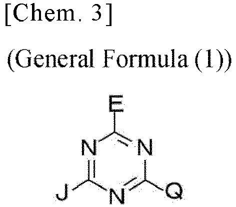

In the general formula (1), J is an organic group including a carbon-carbon double bond. E is a group including an OH group or an OH-generating group. Q is an organic group including a carbon-carbon double bond, which is equal to or different from the J, or NR₁(R₂). The R₁ and the R₂ are each H, a hydrocarbon group having from 1 to 24 carbon atoms, or -RSi(R')ₙ₁(OR")₃₋ₙ₁, which may identical or different. The R is a linear divalent hydrocarbon group having from 1 to 12 carbon atoms. The R' is a linear hydrocarbon group having from 1 to 4 carbon atoms. The R" is H or a linear hydrocarbon group having from 1 to 4 carbon atoms. The n1 is an integer from 0 to 2.

In the general formula (1), the E is preferably the NR₁(R₂).

In other words, the compound (α) is preferably represented by the following general formula (2).

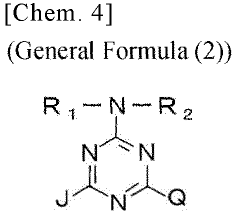

In the general formula (2), the Q is preferably the J.

In other words, the compound (α) is preferably represented by the following general formula (3).

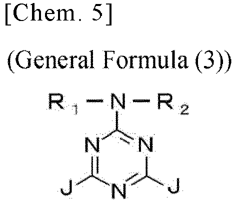

In addition, in the general formula (2), the Q is preferably the NR₁(R₂).

In other words, the compound (α) is preferably represented by the following general formula (4).

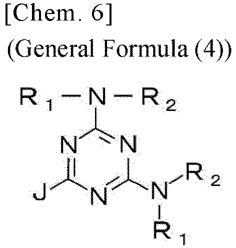

The carbon-carbon double bond of the organic group including the carbon-carbon double bond can react with a carbon-carbon double bond or the like included in the polymer material B in a base B as described below. The organic group may have a benzene ring. In a case where the organic group has a benzene ring, the organic group has a carbon-carbon double bond besides the carbon-carbon double bond included in the benzene ring.

The compound (α) preferably includes, in one molecule, two or more, more preferably from two to four, even more preferably four carbon-carbon double bonds that can react with a carbon-carbon double bond or the like included in the base B described later.

The compound (α) includes two or more carbon-carbon double bonds in one molecule, and thus increasing the bonding strength.

The organic group including the carbon-carbon double bond may include nitrogen or sulfur.

Examples of the organic group including the carbon-carbon double bond include the following functional groups.

CH₂ = CHNH-,

CH₂ = CH(CH₂)NH-,

CH₂ = CH(CH₂)ₙ₂NH(n2 = from 2 to 16),

CH₂ = CHCH₂(N-)CH₂CH = CH₂,

CH₂ = C(CH₃)CH₂NH-,

CH₂ = CHCH₂(N-)C(CH₃)₃,

CH₂ = CHC₆H₄NH-,

CH₂ = CHC₆H₄CH₂NH-,

CH₂ = C(CH₃)(C = O)NH-,

CH₂ = CHCH₂NH(C = O)NH-,

C₆H₅(N-)CH₂CH = CH₂,

-NH(NH₂)C₃N₃CH = CH₂,

CH₂ = CHO-,

CH₂ = CH(CH₂)O-,

CH₂ = CH(CH₂)ₙ₃O-(n3 = from 2 to 16),

CH₂ = C(CH₃)CH₂O-,

CH₂ = CHC₆H₄O-,

CH₂ = CHC₆H₄CH₂O-,

CH₂ = CH-O(CH₂)ₙ₄O-(n4 = from 1 to 16),

CH₂ = CH-O(CH₂)₂O-(CH₂)₂O-,

CH₂ = CHS-,

CH₂ = CH(CH₂)S-,

CH₂ = CH(CH₂)ₙ₅S-(n5 = from 2 to 16),

CH₂ = C(CH₃)CH₂S-,

CH₂ = CHC₆H₄S-,

CH₂ = CHC₆H₄CH₂S-,

(CH₂ = CHCH₂NCH₂CH = CH₂)₂C₃N₃S-,

(CH₂ = CHCH₂NH)₂C₃N₃S-,

(CH₂ = CHCH₂NCH₂CH = CH₂)C₃N₃(SH)S-,

(CH₂ = CHCH₂NH)C₃N₃(SH)S-,

CH₂ = CHCOO-(CH₂)ₙ₇-S-(n7 = from 1 to 16),

CH₂ = C(CH₃)COO-(CH₂)ₙ₈-S-(n8 = from 1 to 16),

CH₂ = CH-,

CH₂ = CH(CH₂)-,

CH₂ = CH(CH₂)ₙ₆-(n6 = from 2 to 16),

CH₂ = C(CH₃)CH₂-,

CH₂ = CHC₆H₄-, or

CH₂ = CHC₆H₄CH₂-.

Next, an example of a method for manufacturing the compound (α) according to the present embodiment will be described with reference to 2,4-bis(diallylamino)-6-(3-triethoxysilylpropyl)amino-1,3,5-triazine (the following formula) as an example. Note that a more specific manufacture method will be illustrated in Example 1 described below.

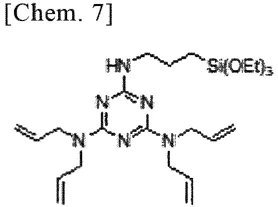

In a three-neck flask, under a nitrogen atmosphere, a mixed solution of 3-aminopropyltriethoxysilane and tetrahydrofuran (THF) is added to a mixed solution of cyanuric chloride and tetrahydrofuran (THF), and further, a mixed solution of triethylamine (TEA) and tetrahydrofuran (THF) is added. Thus, 6-(3-triethoxysilylpropylamino)-1,3,5-triazine-2,4-dichloride is produced as an intermediate by the reaction of the following chemical reaction formula:

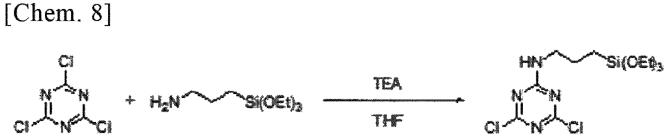

Next, a mixed solution of diallylamine and tetrahydrofuran (THF) is added to a mixed solution of the intermediate and tetrahydrofuran (THF). Thus, 2,4-bis(diallylamino)-6-(3-triethoxysilylpropyl)amino-1,3,5-triazine is produced as the compound (α) by the reaction of the following chemical reaction formula:

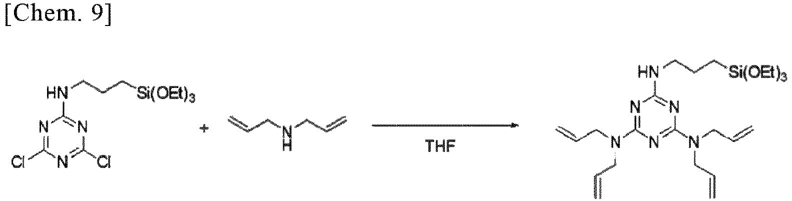

Note that in the chemical reaction formula above for producing the intermediate, only one group including an alkoxysilyl group is bonded to the triazine ring. But two groups each including an alkoxysilyl group may be bonded to the triazine ring by adjusting the 3-aminopropyltriethoxysilane with respect to the amount of the cyanuric chloride.

Furthermore, in the reaction formula above for producing the compound (α) from the intermediate, the "CH₂ = CH(CH₂)NH-" is bonded to the triazine ring with the use of the diallylamine. But the following organic groups may be bonded to the triazine ring with the use of an amine that is separate from the diallylamine.

CH₂ = CHNH-,

CH₂ = CH(CH₂)ₙ₂NH-(n2 = from 2 to 16),

CH₂ = CHCH₂(N-)CH₂CH = CH₂,

CH₂ = C(CH₃)CH₂NH-,

CH₂ = CHCH₂(N-)C(CH₃)₃,

CH₂ = CHC₆H₄NH-,

CH₂ = CHC₆H₄CH₂NH-,

CH₂ = C(CH₃)(C = O)NH-,

CH₂ = CHCH₂NH(C = O)NH-,

C₆H₅(N-)CH₂CH = CH₂,

-NH(NH₂)C₃N₃CH = CH₂

In addition, the following organic groups may be bonded to the triazine ring with the use of an alcohol instead of the diallylamine.

CH₂ = CHO-,

CH₂ = CH(CH₂)O-,

CH₂ = CH(CH₂)ₙ₃O-(n3 = from 2 to 16),

CH₂ = C(CH₃)CH₂O-,

CH₂ = CHC₆H₄O-,

CH₂ = CHC₆H₄CH₂O-,

CH₂ = CH-O(CH₂)ₙ₄O-(n4 = from 1 to 16),

CH₂ = CH-O(CH₂)₂O-(CH₂)₂O-

Furthermore, the following organic groups may be bonded to the triazine ring with the use of a thiol instead of the diallylamine.

CH₂ = CHS-,

CH₂ = CH(CH₂)S-,

CH₂ = CH(CH₂)ₙ₅S-(n5 = from 2 to 16),

CH₂ = C(CH₃)CH₂S-,

CH₂ = CHC₆H₄S-,

CH₂ = CHC₆H₄CH₂S-,

(CH₂ = CHCH₂NCH₂CH = CH₂)₂C₃N₃S-,

(CH₂ = CHCH₂NH)₂C₃N₃S-,

(CH₂ = CHCH₂NCH₂CH = CH₂)C₃N₃(SH)S-,

(CH₂ = CHCH₂NH)C₃N₃(SH)S-,

CH₂ = CHCOO-(CH₂)ₙ₇-S-(n7 = from 1 to 16),

CH₂ = C(CH₃)COO-(CH₂)ₙ₈-S-(n8 = from 1 to 16)

In addition, the following organic groups may be bonded to the triazine ring with the use of a Grignard reagent instead of the diallylamine.

CH₂ = CH-,

CH₂ = CH(CH₂)-,

CH₂ = CH(CH₂)ₙ₆-(n6 = from 2 to 16),

CH₂ = C(CH₃)CH₂-,

CH₂ = CHC₆H₄-,

CH₂ = CHC₆H₄CH₂-

Next, the bonding agent according to the present embodiment will be described.

The bonding agent according to the present embodiment contains the compound (α) according to the present embodiment.

The bonding agent according to the present embodiment may have a solvent.

Examples of the solvent include water, alcohols (e.g., methanol, ethanol, isopropanol, ethylene glycol, propylene glycol, cellosolve, carbitol), ketones (e.g., acetone, methyl ethyl ketone, cyclohexanone), aromatic hydrocarbons (e.g., benzene, toluene, xylene), aliphatic hydrocarbons (e.g., hexane, octane, decane, dodecane, octadecane), esters (e.g., ethyl acetate, methyl propionate, methyl phthalate), and ethers (e.g., tetrahydrofuran, ethyl butyl ether, anisole).

A concentration of the compound (α) in the bonding agent according to the present embodiment is preferably from 0.0001 to 10 mass%, more preferably from 0.01 to 5.0 mass%, and even more preferably from 0.1 to 3.0 mass%.

The bonding agent according to the present embodiment is preferably used for bonding different materials to each other.

The bonding agent according to the present embodiment is preferably used for bonding the material A and the polymer material B. Specifically, the bonding agent according to the present embodiment is used for bonding a base A having the material A on a surface A and the base B having the polymer material B on a surface B. The bonding agent according to the present embodiment is used such that the surface A and the surface B come into contact with each other with the bonding agent interposed between the surface A and the surface B.

The material A is a material that is different from the polymer material.

The polymer material B is preferably a polymer material having a "carbon-carbon double bond" that can react with the "carbon-carbon double bond" included in the compound (α).

Note that in the present embodiment, "the polymer material having a 'carbon-carbon double bond' that can react with the 'carbon-carbon double bond' included in the compound (α)" is a concept that also encompasses "a polymer material that is modified to have a 'carbon-carbon double bond' that can react with the 'carbon-carbon double bond' included in the compound (α)".

In other words, in the present embodiment, "the polymer material having a 'carbon-carbon double bond' that can react with the 'carbon-carbon double bond' included in the compound (α)" means a polymer material that is modified or not modified to have a "carbon-carbon double bond" that can react with the "carbon-carbon double bond" contained in the compound (α).

Examples of the polymer material having a "carbon-carbon double bond" that can react with the "carbon-carbon double bond" included in the compound (α) include a polyphenylene ether (m-PPE), which is a resin modified to have a carbon-carbon double bond in an end or side chain.

Furthermore, examples of the polymer material having a "carbon-carbon double bond" that can react with the "carbon-carbon double bond" included in the compound (α) include polybutadiene, unsaturated polyester, bismaleimide triazine, natural rubber (NR), butadiene rubber (BR), styrene-butadiene rubber (SBR), acrylonitrile-butadiene rubber (NBR), butyl rubber (isobutylene-isoprene copolymer)(IIR), ethylene-propylene rubber (EPDM), and chloroprene rubber (CR).

Furthermore, examples of the polymer material having a "carbon-carbon double bond" that can react with the "carbon-carbon double bond" included in the compound (α) also include the polymer materials listed below, which are modified to have carbon-carbon double bonds:
such as polyethylene (PE), polypropylene (PP), polystyrene (PS), cycloolefin polymer (COP), cycloolefin copolymer (COC), polyimide, polyphenylene sulfide (PPS), polysulfone, polyethersulfone, polyetheretherketone, fluororesin, silicone resin, polyamide, polyester, and a liquid crystal polymer (LCP).

In addition, the base body B may include additives, as necessary.

Examples of the additives include crosslinking agents, crosslinking accelerators, crosslinking aids, radical initiators, cationic initiators, photopolymerization initiators, anti-scorching agents, stabilizers, anti-aging agents, ultraviolet inhibitors, fillers, reinforcing agents, plasticizers, softeners, colorants, viscosity modifiers, and flame retardants.

Various types of the polymerization initiators, crosslinking agents, crosslinking promoters, and crosslinking aids are used for the additives. Examples include peroxides, cationic polymerization initiators, photopolymerization initiators, sulfur, sulfur-based crosslinking accelerators, polyol-based crosslinking agents, polyamine-based crosslinking agents, polythiol-based crosslinking agents, acrylate-based crosslinking aids, methacrylate-based crosslinking aids, and allyl crosslinking aids. Specifically, the examples include azobisbutyronitrile, benzophenone, Michler's ketone, benzoin isopropyl ether, chlorothioxanthone, isopropyl thioxanthone, benzyldimethylketal, acetophenone diethyl ketal, α-hydroxycyclohexyl phenyl ketone, and 2-hydroxy-2-methylphenylpropane. The examples also include acetophenone derivative compounds (e.g., 4-(2-hydroxyethoxy)phenyl(2-hydroxy -2-propyl)ketone, α-hydroxy-α,α'-dimethylacetophenone, methoxyacetophenone, 2,2-dimethoxy-2-phenylacetophenone). The examples also include benzoin ether-based compounds (e.g., benzoin ethyl ether, benzoin propyl ether). The examples also include ketal derivative compounds such as benzyl dimethyl ketal. The examples also include halogenated ketones, acylphosphine oxides, acylphosphonates, bis(2,6-dimethoxybenzoyl)-2,4,4-trimethylpentylphosphine oxide, phenyldimethylsulfonium chloride, and triarylsulfonium hexafluorophosphate. The examples also include triazine dithiol-based crosslinking agents, resin crosslinking agents, polyol crosslinking agents, H-terminated siloxane-based crosslinking agents, and silanol-condensed crosslinking agents. The examples also include dibenzothiazoyl disulfide, 4-morpholinodithiobenzothiazole, N-cyclohexyl-2-benzothiazoylsulfenamide, N-t-butyl-2-benzothiazoylsulfenamide, N-oxydiethylene-2-benzothiazoylsulfenamide, N-diisopropyl-2-benzothiazoylsulfenamide, N-dicyclohexyl-2-benzothiazoylsulfenamide, tetramethylthiuram disulfide, tetraethylthiuram disulfide, tetrabutylthiuram disulfide, tetraoctylthiuram disulfide, amines, hexamethylenetetramine, zarigen, quaternary ammonium salts, phosphonium salts, dialkyltin organic acid salts, titanates, polyethylene glycol, chloroplatinic acid, zinc oxide, magnesium oxide, calcium oxide, barium oxide, aluminum oxide, calcium hydroxide, tin oxide, iron oxide, calcium hydroxide, calcium carbonate, magnesium carbonate, sodium fatty acids, calcium octylate, potassium isooctylate, potassium butoxide, cesium octylate, potassium isostearate, polyethylene glycol, polypropylene glycol, hexanediol, cyclohexanediol, dodecanediol, hexamethylenediamine, dodecanediamine, polyethylene glycol with a diamino terminal, polypropylene glycol with a diamino terminal, benzene dithiol, hexane dithiol, 1,10-decanedithiol, 1,12-dodecanedithiol, polyethylene glycol diacrylate, polyethylene glycol dimethacrylate, polypropylene glycol diacrylate, polypropylene glycol dimethacrylate, diallyl ethers, triallyl isocyanurates, and triallyl cyanurates.

The base B may have a sheet-like, plate-like, columnar, rod-like, frame-shaped, box-like, fibrous, or thread-like shape. In addition, the base B may have the shape of a film, a woven fabric, a nonwoven fabric, or a foam body.

The base B contains therein, as necessary, various types of fillers and reinforcing agents in appropriate amounts. For example, the base B includes various types of carbon black, calcium carbonate, talc, clay, kaolin, glass, wet silica, and dry silica, as necessary. The base B includes rayon, nylon, polyester, vinylon, a steel, Kevlar, a carbon fiber, and a glass fiber, a cloth, as necessary. The base B includes metal particles (such as copper, nickel, silver, gold, and tin), as necessary. The base B includes a carbon particle, as necessary. The base B includes a conductive material, as necessary. The base B includes a heat-transfer material such as alumina, silicon nitride, alumina nitride, silicon carbide, and diamond, as necessary. A content is 200 parts by mass or less with respect to 100 parts by mass of the polymer material. Typically, the content is 100 parts by mass or less.

The base B contains, as necessary, a stabilizer in an appropriate amount. The stabilizer is, for example, an anti-aging agent or an ultraviolet absorber. The stabilizer is, for example, an amine-ketone-based condensate such as poly(2,2,4-trimethyl-1,2-dihydroquinoline) or 6-ethoxy-1,2-dihydro-2,2,4-trimethylquinoline. The stabilizer is an aromatic secondary amine compound such as octyldiphenylamine, 4,4-bis(α,α-dimethylbenzyl)diphenylamine, N,N-diphenyl-p-phenylenediamine, N-phenyl-N'-isopropyl-p-phenylenediamine, or N-phenyl-N'-isopropyl-1,3-dimethylbutyl-p-phenylenediamine. The stabilizer is a mono- or bis-phenol-based compound such as a styrenated phenol, 2,6-di-t-butyl-4-phenol, 2-t-butyl-6-(3-t-butyl-2-hydroxy-5-methylbenzyl)-4-methylphenyl acrylate, or 2,2-methylenebis(4-methyl-6-t-butylphenol), or 4,4-thiobis(3-methyl-6-t-butylphenol)2,5-di-t-butylhydroquinone. The stabilizer is a sulfur-based or phosphorus-based compound such as 2-mercaptobenzimidazole, 2-mercaptobenzimidazole zinc, nickel dimethyldithiocarbamate, 1,3-bis(dimethylaminopropyl)thiourea, dilauryl-3,3-thiodipropionate, or tris(nonylated phenyl)phosphite. The content is preferably 30 parts by mass or less, more preferably from 0.5 to 5 parts by mass, even more preferably from 0.5 to 3 parts by mass with respect to 100 parts by mass of the polymer material B.

The base B contains a softener, a plasticizer, a processing aid, a viscosity modifier, a colorant, and the like in appropriate amounts, as necessary.

In the case where the base B is used as a base constituting a printed circuit board, the base B preferably has an elastic modulus of 2.0 GPa or greater, more preferably 2.3 GPa or greater. In addition, the base B preferably has an elastic modulus of 4.5 GPa or less, more preferably 2.6 GPa or less.

The material A preferably has a functional group that can react with "at least one type of functional group selected from the group consisting of an OH group and an OH-generating group" included in the compound (α).

Examples of the functional group that can react with "at least one type of functional group selected from the group consisting of an OH group and an OH-generating group" include an OH group and an OH-generating group.

In addition, in a case where the material A has no functional group that reacts with "at least one type of functional group selected from the group consisting of an OH group and an OH-generating group" included in the compound (α), the surface A of the base A is preferably subjected to one or more treatments selected from the group consisting of a degreasing treatment, a corona discharge treatment, a plasma discharge treatment, ultraviolet irradiation, an acid treatment, an alkali treatment, a water vapor treatment, and a chemical conversion treatment. This preferably results in the substrate A having an OH group on the surface A.

The substrate A has a functional group that can react with "at least one type of functional group selected from the group consisting of an OH group and an OH-generating group" on the surface A, and has the functional group to react with "at least one type of functional group selected from the group consisting of an OH group and an OH-generating group" included in the compound (α) and then to form a chemical bond with the compound (α). As a result, the bonding strength can be further enhanced.

Examples of the material A include metal materials, ceramics, and polymer materials.

Examples of the metal material include single metals and alloys.

Examples of the single metals include Be, Mg, Ca, St, Ba, Ra, Sc, It, Ti, Zr, V, Nb, Ta, Cr, Mo, W, Mn, Fe, Co, rhodium, Ir, Ni, palladium, Pt, Cu, Ag, Au, Zn, Cd, Hg, Al, Ge, Sn, Pb, An, Bi, and neodymium.

Examples of the alloys include iron alloys, copper alloys, aluminum alloys, magnesium alloys, zinc alloys, tin alloys, nickel alloys, gold alloys, silver alloys, platinum alloys, palladium alloys, lead alloys, titanium alloys, cadmium alloys, zirconium alloys, cobalt alloys, chromium alloys, molybdenum alloys, tungsten alloys, manganese alloys, ferritic stainless steel, martensitic stainless steel, austenitic stainless steel, precipitation strengthening stainless steel, nickel-titanium alloys, iron-manganese-titanium alloys, and superelastic alloys (nickel-titanium alloys).

In addition, the metal may also be a functional metal, an amorphous metal, a fiber-reinforced metal, a shape memory alloy, and a superelastic alloy.

Examples of the ceramics include oxides of the metal, pottery, glass, cement, and gypsum. The ceramics may also be vitreous enamel and the like The ceramics may also be diamond-based. The ceramics may also be metal oxides such as alumina, mullite, zirconia, and zinc oxides. The ceramics may also be hydroxides such as a hydroxyapatite. The ceramics may also be carbides such as a silicon carbide. The ceramics may also be carbonate-based. The ceramics may also be nitride-based, such as a silicon nitride, a silicon nitride, and an aluminum nitride. The ceramics may also be halide-based, such as a fluorite. The ceramics may also be phosphate-based, such as apatite. The ceramics may also be a barium titanate and a lead titanate zirconate. The ceramics may also be ferrite, steatite, forsterite, cordierite, sialon, zircon, and the like. In addition, the ceramics may also be high-temperature superconducting ceramics, machinable ceramics, and the like. The ceramics may also be fiber-reinforced ceramics such as carbon fibers, organic fibers, metal fibers, and glass fibers.

Examples of the polymer material for the material A include celluloses, derivatives of celluloses, hydroxyethyl celluloses, starches, cellulose diacetates, surface-saponified vinyl acetate resins, low-density polyethylene, high-density polyethylene, polypropylene, ethylene-propylene copolymers, petroleum resins, polystyrene, syndiotactic polystyrene, styrene copolymers, chroman-indene resins, terpene resins, styrene-divinylbenzene copolymers, acrylonitrile-butadiene-styrene copolymer resins, methyl polyacrylate, ethyl polyacrylate, polyacrylonitrile, methyl polyacrylate, methyl polymethacrylate, ethyl polymethacrylate, polycyanoacrylate, polyvinyl acetate, ethylene-vinyl acetate copolymer resins, polyvinyl alcohol, polyvinyl formal, polyvinyl acetal, vinyl acetate copolymers, polyvinyl chloride, vinyl chloride-vinyl acetate copolymers, vinyl chloride-ethylene copolymers, polyvinylidene fluoride, vinylidene fluoride-ethylene copolymers, vinylidene fluoride-propylene copolymers, poly 1,4-transpolybutadiene, poly 1,2-transpolybutadiene, polyoxymethylene, polyethylene glycol, polypropylene glycol, phenol-formalin resins, cresol-formalin resins, resorcin resins, melamine resins, xylene resins, toluene resins, glyptal resins, modified glyptal resins, polyethylene terephthalate, polybutylene terephthalate, unsaturated polyester resins, polyester acrylate, allyl ester resins, polycarbonate, 6-nylon, 6',6-nylon, 6', 10-nylon, polyimide, polyamide, polybenzimidazole, polybenzoxazole, polybenzimidazole, polyamide-imide, silicon resins, addition-curable silicone rubbers, polymerization-curable silicone rubbers, condensation-curable silicone rubbers, addition-curable silicone resins, furan resins, polyurethane resins, epoxy resins, polyphenylene oxide, polydimethylphenylene oxide, blended polymers (polymer alloys) of polyphenylene oxide or polydimethylphenylene oxide and triallyl isocyanurate, blended polymers (polymer alloys) of polyphenylene oxide or polydimethylphenylene oxide and triallyl isocyanurate peroxide, polyxylene, polyphenylene sulfide, polycycloolefins, polysulfone, polyethersulfone, polyetheretherketone, polyimide, liquid crystal resins (LCP), natural rubbers, 1,4-cis butadiene rubber, isoprene rubbers, polychloroprene, styrene-butadiene copolymer rubbers, hydrogenated styrene-butadiene copolymer rubbers, acrylonitrile-butadiene copolymer rubbers, hydrogenated acrylonitrile-butadiene copolymer rubbers, polybutene rubbers, polyisobutylene rubbers, ethylene-propylene rubbers, ethylene-propylene-diene rubbers, ethylene oxide-epichlorohydrin copolymer rubbers, chlorinated polyethylene rubbers, chlorine sulfonated polyethylene rubbers, alkylated chlorsulphone polyethylene rubbers, chloroprene rubbers, chlorinated acrylic rubbers, brominated acrylic rubbers, fluorine rubbers, epichlorohydrin copolymer rubbers, chlorinated ethylene-propylene rubbers, chlorinated butyl rubbers, brominated butyl rubbers, homopolymer rubbers of tetrafluoroethylene, hexafluoropropylene, vinylidene fluoride, and tetrafluoroethylene, and binary and tertiary copolymer rubbers thereof, ethylene-tetrafluoroethylene copolymer rubbers, propylene-tetrafluoroethylene copolymer rubbers, ethylene acrylic rubbers, peroxide-type silicone rubbers, addition-type silicone rubbers, condensation-type silicone rubbers, epoxy rubbers, urethane rubbers, and both telastomers with unsaturated group at both ends.

The material A is preferably a material that can form a coordinate bond with the triazine ring included in the compound (α).

Formation of a coordinate bond between the material A and the triazine ring included in the compound (α) can increase the bonding strength.

From the perspective of capability to form a coordinate bond with the triazine ring, the material A is preferably a metal material, and more preferably Cu, Zn, Ni, and Fe.

The base A may have a sheet-like, plate-like, columnar, rod-like, frame-shaped, box-like, fibrous, or thread-like shape. In addition, the base A may have the shape of a film, a woven fabric, a nonwoven fabric, or a foam body.

In a related art, when a flexible printed circuit board(FPC) is prepared by bonding the base A with copper at the surface and the base B as a resin substrate, a surface roughness of the surface of the base A having copper at the surface is made larger to exert an anchoring effect to increase the bonding strength between the base A and the base B.

However, large roughness of the surface of the base A may cause a conduction loss, and consequently causing a transmission loss. As a result, it will be difficult to secure the quality of transmission signals in a highfrequency region.

The use of the bonding agent according to the present embodiment increase, however, the bonding strength between the base A with copper at the surface and the base B as a resin substrate, even with the small surface roughness of the surface of the base A with copper at the surface. As a result, the quality of transmission signals is easily secured, in particular, in a highfrequency region.

Accordingly, the bonding agent according to the present embodiment is particularly preferably used for manufacturing a flexible printed circuit board (FPC) by bonding the base A with copper at the surface and the base B as a resin substrate.

The bonded body according to the present embodiment is a bonded body formed by bonding the material A and the polymer material B with the bonding agent according to the present embodiment.

The printed circuit board according to the present embodiment includes the bonded body according to the present embodiment.

The method for manufacturing a bonded body according to the present embodiment is a method for preparing the bonded body formed by bonding the base A that has the material A at the surface A and the base B that has the polymer material B at the surface B with the bonding agent.

In addition, the method for manufacturing a bonded body according to the present embodiment includes: (X) providing the bonding agent according to the present embodiment on the surface A; (Y) bringing the base A and the base B to abut each other such that the surface A and the surface B are brought into contact with the bonding agent interposed between the surface A and the surface B; and (Z) applying a pressure to the contact surface between the surface A and the surface B with the bonding agent interposed between the surface A and the surface B to form the bonded body.

In the method for manufacturing a bonded body according to the present embodiment, in the (X), the base A and the compound (α) included in the bonding agent according to the present embodiment form a chemical bond, and this makes a triazine ring and a carbon-carbon double bond to be present at the surface of the base A.

Then, in the (Z), the base B and the carbon-carbon double bond of the compound (α) form a chemical bond, and this increases the bonding strength between the base A and the base B.

In addition, the method for manufacturing the bonded body according to the present embodiment further includes, before the (X), (A) producing an OH group at the surface A, the producing including subjecting the surface A to one or more treatments selected from the group consisting of a degreasing treatment, a corona discharge treatment, a plasma discharge treatment, ultraviolet irradiation, an acid treatment, an alkali treatment, a water vapor treatment, and a chemical conversion treatment.

In the (X), the bonding agent is provided on the surface A by immersing the surface A in the bonding agent, by spraying the bonding agent onto the surface A, or applying the bonding agent to the surface A with a coating device.

In the (Z), a pressure is applied to the contact surface between the surface A and the surface B with the bonding agent interposed between the surface A and the surface B such that the polymer material B and the adhesive are brought into contact with each other.

In the (Z), a pressure is applied to the contact surface at from 0.01 to 50 MPa, more preferably from 0.1 to 5 MPa.

In addition, the application of the pressure in the (Z) is preferably performed under a temperature condition from 0 to 350°C, more preferably from 40 to 350°C, even more preferably from 80 to 350°C.

In addition, in the (Z), the pressure may be applied to the contact surface while the contact surface is heated.

### <Other Embodiments>

Next, other embodiments will be described below.

Note that descriptions that are duplicated from the present embodiment will be omitted, and that matters that are not particularly described in other embodiments are considered the same as described in the present embodiment.

A method for manufacturing a bonded body according to another embodiment is a method for preparing a bonded body formed by a metal material and the polymer material B with the bonding agent.

In the method for manufacturing a bonded body yet according to another embodiment, the bonding agent according to the present embodiment is used. The bonding agent has an alkoxysilyl group as the OH-generating group.

Furthermore, the method for manufacturing a bonded body according to yet another embodiment includes: (X') providing the bonding agent on a surface B of a base B, the base B having the polymer material B at the surface B, and having a triazine ring and an alkoxysilyl group to be present at the surface B; and (YZ') forming the bonded body by providing an electroless plating solution on the triazine ring and the alkoxysilyl group of the surface B.

In the method for manufacturing a bonded body according to another embodiment, in the (X'), the base B and the compound (α) included in the bonding agent according to the present embodiment form a chemical bond, and this makes the triazine ring and the alkoxysilyl group to be present at the surface of the base B.

Then, in the (YZ'), formation of a chemical bond between the metal material and the alkoxysilyl group increases the bonding strength between the metal material and the polymer material B.

In addition, in the (YZ'), formation of a coordinate bond between the metal material and the triazine ring increases the bonding strength between the metal material and the polymer material B.

In the (X'), the bonding agent is provided on the surface B by immersing the surface B in the bonding agent, by spraying the bonding agent onto the surface B, or applying the bonding agent to the surface A with a coating device.

The electroless plating solution contains a metal material.

Examples of the metal material contained in the electroless plating solution include Ni and Cu.

In addition, after the (X'), a catalyst is preferably adsorbed on the triazine ring or the alkoxysilyl group at the surface B before the (YZ').

Examples of the catalyst include Pd and Ag.

The electroless plating solution preferably includes a reducing agent.

The electroless plating solution contains a reducing agent, and thus oxidation of the reducing agent in the (YZ') releases the electrons, which facilitate deposition of the metal material. As a result, the bonding strength between the metal material and the polymer material B can be further enhanced.

The bonding agent according to another embodiment is a bonding agent for use in bonding the metal material and the polymer material B.

In addition, the bonding agent according to yet another embodiment has a peel strength of 5 N/cm or greater, preferably 6 N/cm or greater, more preferably from 6 to 20 N/cm.

Note that the peel strength of the bonding agent according to another embodiment refers to the peel strength in peeling off at a speed of 50 mm/min in accordance with the method of JIS K6854-1: 1999
"Adhesives-Determination of peel strength of bonded assemblies- Part 1: 90° peel".

In addition, the peel strength of the bonding agent according to yet another embodiment preferably has a peel strength of 5 N/cm or greater, more preferably 6 N/cm or greater, even more preferably from 6 to 20 N/cm, after a solder reflow test at 260°C.

Note that reflow test refers to the reflow method described in JIS C60068-2-58: 2016.

As the metal material, the metal material described as the material A according to the present embodiment can be used.

The bonding agent according to another embodiment is preferably used for bonding a copper foil having copper as the metal material.

A surface roughness (Rz) of the bonding surface of the copper foil is preferably from 0.5 to 1.5 µm, more preferably from 0.5 to 1.0 µm, even more preferably 0.8 µm.

Note that the "surface roughness (Rz)" refers to the "arithmetic mean roughness of surface roughness" determined in accordance with JIS B0601: 2013. In addition, the "arithmetic mean roughness of the surface roughness" refers to a value determined by summing the absolute values of the deviations from the average line to a measurement curve and averaging the sum for the reference length.

As the polymer material B, the polymer material B according to the present embodiment can be used.

The bonding agent according to another embodiment preferably contains the compound (α) according to the present embodiment.

The bonded body according to another embodiment is a bonded body formed by bonding the metal material and the polymer material B with the bonding agent.

In addition, the bonded body according to yet another embodiment has a peel strength of 5 N/cm or greater, preferably 6 N/cm or greater, more preferably from 6 to 20 N/cm.

Note that the peel strength of the bonded body according to another embodiment refers to the peel strength in peeling off the metal material or the polymer material at a speed of 50 mm/min in accordance with the method of JIS K6854-1: 1999 "Adhesives-Determination of peel strength of bonded assemblies- Part 1: 90° peel".

In addition, the peel strength of the bonded body according to another embodiment preferably has a peel strength of 5 N/cm or greater, more preferably 6 N/cm or greater, even more preferably from 6 to 20 N/cm, after a solder reflow test at 260°C.

As the metal material, the metal material described as the material A according to the present embodiment can be used.

The bonded body according to another embodiment is preferably formed by bonding copper foil having copper as the metal material.

The surface roughness (Rz) of the bonding surface of the copper foil is preferably from 0.5 to 1.5 µm, more preferably from 0.5 to 1.0 µm, even more preferably 0.8 µm.

The bonding agent in the bonded body according to another embodiment preferably contains the compound (α) according to the present embodiment.

The bonding agent in the bonded body according to another embodiment may be the bonding agent according to the present embodiment, or may be the bonding agent according to the other embodiments.

The printed circuit board according to another embodiment includes the bonded body according to another embodiment.

### Examples

Next, the present disclosure will be described more specifically with reference to an example and comparative examples. Note that the present disclosure is not to be considered limited to these examples at all.

### Example 1

### (Synthesis 1: Production of Intermediate)

In a 500 mL three-neck flask, a stir bar and 10.0 g (54 mmol) of cyanuric chloride (from Kanto Chemical Industry Co., Ltd.) were charged.

Next, a thermometer and a dropping funnel were attached to the three-neck flask.

Then, a nitrogen atmosphere was introduced into the three-neck flask.

Next, 100 mL of tetrahydrofuran (THF) was added into the three-neck flask, and the mixture in the three-neck flask was cooled down to -10°C.

Then, a mixed solution of 11.95 g (54 mmol) of 3-aminopropyltriethoxysilane (available from Tokyo Chemical Industry Co., Ltd.) and 20 mL of tetrahydrofuran (THF) (available from Kanto Chemical Industry Co., Ltd.) was gradually added dropwise into the three-neck flask over 30 minutes.

Next, a mixed solution of 5.55 g (59.4 mmol) of triethylamine (TEA) (available from Tokyo Chemical Industry Co., Ltd.) and 20 mL of tetrahydrofuran (THF) was gradually added dropwise into the three-neck flask over 30 minutes.

Then, the contents in the three-neck flask were stirred with the use of the stir bar while keeping the temperature at -10°C in the three-neck flask. Thus, an intermediate 6-(3-triethoxysilylpropylamino)-1,3,5-triazine -2,4-dichloride was formed by the following reaction.

The reaction for the intermediate formation is shown below.

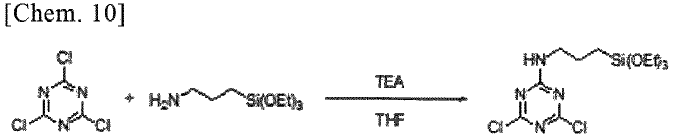

After the reaction, the triethylamine hydrochloride, which was a byproduct, was filtered out from the contents in the three-neck flask.

Then, the contents from which the triethylamine hydrochloride as a byproduct had been filtered out were concentrated in a rotary evaporator and dried under reduced pressure to obtain purified 6-(3-triethoxysilylpropylamino)-1,3,5-triazine-2,4-dichloride.

### (Synthesis 2: Production of Compound (α))

In a 300 mL three-neck flask, a stir bar and 15.0 g (40.6 mmol) of the purified 6-(3-triethoxysilylpropylamino)-1,3,5-triazine-2,4-dichloride were charged.

Next, a condenser and a dropping funnel were attached to the three-neck flask.

Then, a nitrogen atmosphere was introduced into the three-neck flask.

Next, 100 mL of tetrahydrofuran (THF) was added into the three-neck flask.

Then, a mixed solution of 23.7 g (243.6 mmol mmol) of diallylamine and 50 mL of tetrahydrofuran (THF) (available from Kanto Chemical Industry Co., Ltd.) was gradually added dropwise into the three-neck flask over 30 minutes.

Next, the temperature in the three-neck flask was gradually increased for reflux in the three-neck flask, and the contents in the three-neck flask were stirred for 48 hours with the use of the stir bar while the reflux performed in the three-neck flask, thereby producing 2,4-bis(diallylamino)-6-(3-triethoxysilylpropyl)amino-1,3,5-triazine as the compound (α) by the following reaction.

The reaction for producing the compound (α) from the intermediate is shown below.

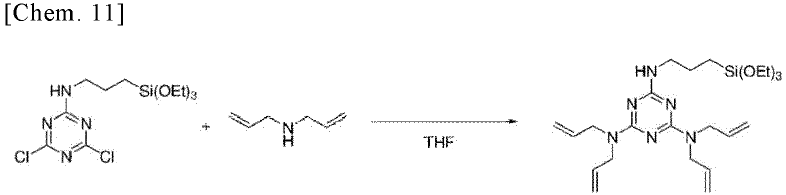

After the reaction, the contents in the three-neck flask were cooled down to room temperature.

Then, the contents were subjected to suction filtration with the use of a filtration aid (trade name: Celite) to obtain a filtrate.

The filtrate was then concentrated in a rotary evaporator and dried under reduced pressure to obtain purified 2,4-bis(diallylamino)-6-(3-triethoxysilylpropyl)amino-1,3,5-triazine.

### (Preparation of Bonding Agent)

The 2,4-bis(diallylamino)-6-(3-triethoxysilylpropyl)amino-1,3,5-triazine as the compound (α) and ethanol (EtOH) were mixed to prepare a bonding agent of 0.1 mass% in the concentration of the compound (α).

### (Preparation of Bonded Body)

As the base A, two sheets of copper foil (non-roughened ultra very low profile ED copper foil T9DA available from Fukuda Metal Foil & Powder Co., Ltd.)(30 mm × 60 mm) having a mat surface (Rz = 0.8 µm) were prepared.

In addition, a prepreg sheet (the resin composition in the prepreg sheet includes a modified polyphenylene ether (m-PPE) having a carbon-carbon double bond at an end and a peroxide as a radical initiator (polymerization initiator))(30 mm × 60 mm) was prepared as the base B. Note that the elastic modulus of the copper foil was 120 GPa. The elastic modulus of the prepreg sheet was 2.6 GPa.

Then, the two sheets of copper foil were immersed in the bonding agent for 1 minute and dried with a dryer, and then heated for 10 minutes in an oven at 120°C.

Next, the copper foil, the prepreg sheet, and the copper foil were stacked in this order and pressed with a press (pressing conditions: "177°C, 0.8 MPa, 30 minutes" → "216°C, 0.8 MPa, 60 minutes") to form a bonded body.

Then, the bonded body was cut to make six bonded bodies of 30 mm × 10 mm.

### (Initial Peel Adhesion Strength Test)

With the use of one of the bonded bodies of 30 mm × 10 mm, one copper foil was peeled off at a speed of 50 mm/min in accordance with the method of JIS K6854-1: 1999 "Adhesives-Determination of peel strength of bonded assemblies- Part 1: 90°peel", and the peel adhesion strength (hereinafter, also referred to as "peel strength") was measured.

The result is shown in Table 1 below.

### (Peel Adhesion Strength after Solder Reflow Test)

Five of the bonded bodies of 30 mm × 10 mm were subjected to a solder reflow test (260°C) (hereinafter, also referred to simply as "reflow test").

Then, the peel strength of each of the five bonded bodies of 30 mm × 10 mm after the reflow test was measured in the same manner as in the initial peel adhesion strength test.

The result (arithmetic mean value, n = 5) are shown in Table 1 below.

### Comparative Example 1

In the same manner as in Example 1 with the exception of immersion in the bonding agent, drying with the dryer, and heating in the oven, a bonded body was prepared, and subjected to the initial peel adhesion strength test and the peel adhesion strength test after the solder reflow test.

The result is shown in Table 1 below.

### Comparative Example 2

In the same manner as in Example 1 with the exception of using vinyltriethoxysilane in place of the compound (α), a bonded body was prepared, and subjected to the initial peel adhesion strength test and the peel adhesion strength test after the solder reflow test.

The result is shown in Table 1 below.

### Comparative Example 3

In the same manner as in Example 1 with the exception of using 3-acryloxypropyltrimethoxysilane in place of the compound (α), a bonded body was prepared, and subjected to the initial peel adhesion strength test and the peel adhesion strength test after the solder reflow test.

The result is shown in Table 1 below.

**[Table 1]**

| | Compounds included in Bonding Agent | Peel Strength (N/cm) | |
|---|---|---|---|
| | | Initial | Reflow |
| Comparative Example 1 | no bonding agent used | 0.4 | 0.2 |
| Comparative Example 2 | vinyltriethoxysilane | 2.4 | 1.9 |
| Comparative Example 3 | 3-acryloxypropyltrimethoxysilane | 2.9 | 3.0 |
| Example 1 | 2,4-bis(diallylamino)-6-(3-triethoxysilylpropyl)amino-1,3,5-triazine | 6.3 | 5.6 |

As shown in Table 1, Example 1 within the scope of the present disclosure was higher in peel strength in both the initial peel adhesion strength test and the peel adhesion strength test after the solder reflow test, as compared with Comparative Example 1 without the bonding agent used and Comparative Examples 2 and 3 without the compound (α) used.

From the foregoing, it is determined that the bonding strength can be increased according to the present disclosure.

Note that the peel strength at which base breakage is believed to occur is 5 N/cm, while the peel strength exceeded this value in Example 1.

Tests were performed in the same manner as the "initial peel adhesion strength test" and the "peel adhesion strength test after the solder reflow test" with the exception that copper foil (H-VLP2 grade) with a mat surface of 1.1 µm in surface roughness (Rz) and copper foil (H-VLP grade) with a mat surface of 1.4 µm in surface roughness (Rz) were used.

The results are shown in Table 2 below, along with the results in Table 1 above.

Note that here are the criteria for peel strength evaluation as follows:
"Excellent": 6.0 N/cm or greater
"Good": 5.0 N/cm or greater and less than 6.0 N/cm
"Poor": less than 5.0 N/cm

**[Table 2]**

| | Compounds included in Bonding Agent | Peel Strength | | | | | |
|---|---|---|---|---|---|---|---|
| | | Rz = 0.8 µm | | Rz = 1.1 µm | | Rz = 1.4 µm | |
| | | Initial | Reflow | Initial | Reflow | Initial | Reflow |
| Comparative Example 1 | no bonding agent used | Poor | Poor | Poor | Poor | Poor | Poor |
| Comparative Example 2 | vinyltriethoxy silane | Poor | Poor | Poor | Poor | Poor | Poor |
| Comparative Example 3 | 3-acryloxypropyltrimethoxysilane | Poor | Poor | Poor | Poor | Poor | Poor |
| Example 1 | 2,4-bis(diallylamino)-6-(3-triethoxysilylpropyl)amino-1,3,5-triazine | Excellent | Good | Excellent | Excellent | Excellent | Excellent |

As shown in Table 2, the aspect in which the bonding agent according to Example 1 within the scope of the present disclosure was used exhibited higher peel strength in both the initial peel adhesion strength test and the peel adhesion strength test after the solder reflow test, compared with the aspect in which no bonding agent was used (corresponding to Comparative Example 1) and the aspects in which the bonding agents containing no compound (α)(bonding agents according to Comparative Examples 2 and 3).

From the foregoing, it is determined that according to the present disclosure, a bonded body can be formed which has peel strength of 5.0 N/cm or more with high bonding strength even if the copper foil varies in surface roughness (Rz).

## Claims

1. A compound having, in one molecule: at least one type of functional group selected from the group consisting of an OH group and an OH-generating group; an organic group including a carbon-carbon double bond; and a triazine ring.

2. The compound according to claim 1, wherein the compound has an alkoxysilyl group as the OH-generating group.

3. The compound according to claim 1 or 2, represented by general formula (1): 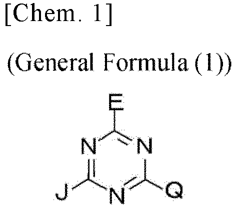 where
J is an organic group including a carbon-carbon double bond,
E is a group including an OH group or an OH-generating group,
Q is an organic group including a carbon-carbon double bond, the organic group being identical to or different from J, or NR₁(R₂),
the R₁ and the R₂ are each H, a hydrocarbon group having from 1 to 24 carbons, or -RSi(R')ₙ₁(OR")₃₋ₙ₁, which may be identical or different,
the R is a linear divalent hydrocarbon group having from 1 to 12 carbons,
the R' is a linear hydrocarbon group having from 1 to 4 carbon atoms,
the R" is H or a linear hydrocarbon group having from 1 to 4 carbons, and
the n1 is an integer from 0 to 2.

4. The compound according to claim 3, wherein E in the general formula (1) is the NR₁(R₂).

5. The compound according to claim 4, wherein Q in the general formula (1) is the J.

6. The compound according to claim 4, wherein Q in the general formula (1) is the NR₁(R₂).

7. The compound according to any one of claims 1 to 6, wherein the compound has, as the organic group including a carbon-carbon double bond, at least one type of functional groups:
CH₂ = CHNH-,
CH₂ = CH(CH₂)NH-,
CH₂ = CH(CH₂)ₙ₂NH-(n2 = from 2 to 16),
CH₂ = CHCH₂(N-)CH₂CH = CH₂,
CH₂ = C(CH₃)CH₂NH-,
CH₂ = CHCH₂(N-)C(CH₃)₃,
CH₂ = CHC₆H₄NH-,
CH₂ = CHC₆H₄CH₂NH-,
CH₂ = C(CH₃)(C = O)NH-,
CH₂ = CHCH₂NH(C = O)NH-,
C₆H₅(N-)CH₂CH = CH₂,
-NH(NH₂)C₃N₃CH = CH₂,
CH₂ = CHO-,
CH₂ = CH(CH₂)O-,
CH₂ = CH(CH₂)ₙ₃O-(n3 = from 2 to 16),
CH₂ = C(CH₃)CH₂O-,
CH₂ = CHC₆H₄O-,
CH₂ = CHC₆H₄CH₂O-,
CH₂ = CH-O(CH₂)ₙ₄O-(n4 = from 1 to 16),
CH₂ = CH-O(CH₂)₂O-(CH₂)₂O-,
CH₂ = CHS-,
CH₂ = CH(CH₂)S-,
CH₂ = CH(CH₂)ₙ₅S-(n5 = from 2 to 16),
CH₂ = C(CH₃)CH₂S-,
CH₂ = CHC₆H₄S-,
CH₂ = CHC₆H₄CH₂S-,
(CH₂ = CHCH₂NCH₂CH = CH₂)₂C₃N₃S-,
(CH₂ = CHCH₂NH)₂C₃N₃S-,
(CH₂ = CHCH₂NCH₂CH = CH₂)C₃N₃(SH)S-,
(CH₂ = CHCH₂NH)C₃N₃(SH)S-,
CH₂ = CHCOO-(CH₂)ₙ₇-S-(n7 = from 1 to 16),
CH₂ = C(CH₃)COO-(CH₂)ₙ₈-S-(n8 = from 1 to 16),
CH₂ = CH-,
CH₂ = CH(CH₂)-,
CH₂ = CH(CH₂)ₙ₆-(n6 = from 2 to 16),
CH₂ = C(CH₃)CH₂-,
CH₂ = CHC₆H₄-,
or
CH₂ = CHC₆H₄CH₂-.

8. A bonding agent containing the compound (α) described in any one of claims 1 to 7.

9. The bonding agent according to claim 8 for use in bonding a material A and a polymer material B.

10. The bonding agent according to claim 9, wherein the material A is a metal material.

11. A bonded body formed by bonding the material A and the polymer material B with the bonding agent described in claim 9 or 10.

12. A printed circuit board comprising the bonded body described in claim 11.

13. A method for manufacturing a bonded body formed by bonding, with a bonding agent, a base A having a material A at a surface A and a base B having a polymer material B at a surface B, the method comprising:
(X) providing the bonding agent described in claim 9 or 10 on the surface A;
(Y) bringing the base A and the base B to abut each other such that the surface A and the surface B are brought into contact with the bonding agent interposed between the surface A and the surface B; and
(Z) applying a pressure to the contact surface between the surface A and the surface B with the bonding agent interposed between the surface A and the surface B to form the bonded body.

14. The method for manufacturing a bonded body according to claim 13, further comprising, before the (X),
(A) producing an OH group at the surface A, the producing including subjecting the surface A to one or more treatments selected from the group consisting of a degreasing treatment, a corona discharge treatment, a plasma discharge treatment, ultraviolet irradiation, an acid treatment, an alkali treatment, a water vapor treatment, and a chemical conversion treatment.

15. The method for manufacturing a bonded body according to claim 14, comprising, after the (X), heating the surface A and the bonding agent to chemically bond the OH group at the surface A and at least one type of functional group selected from the group consisting of an OH group and an OH-generating group of the compound (α) by dehydration condensation.

16. The method for manufacturing a bonded body according to any one of claims 13 to 15, wherein, in the (X), the bonding agent is provided on the surface A by immersing the surface A in the bonding agent, by spraying the bonding agent onto the surface A, or by applying the bonding agent to the surface A with a coating device.

17. The method for manufacturing a bonded body according to any one of claims 13 to 16, wherein, in the (Z), a pressure is applied to the contact surface between the surface A and the surface B with the bonding agent interposed between the surface A and the surface B such that the polymer material B and the adhesive are brought into contact with each other.

18. The method for manufacturing a bonded body according to any one of claims 13 to 17, wherein the pressure is applied in the (Z) under a temperature condition from 0 to 350°C.

19. The method for manufacturing a bonded body according to any one of claims 13 to 18, wherein, in the (Z), the pressure is applied to the contact surface while the contact surface is heated.

20. A method for manufacturing a bonded body, the bonding body being formed by bonding a metal material and a polymer material B with a bonding agent, the method comprising:
using the bonding agent described in claim 10, the bonding agent having an alkoxysilyl group as the OH-generating group, providing the bonding agent on a surface B of a base B, the base B having the polymer material B at the surface B, and having the triazine ring and the alkoxysilyl group to be present at the surface B; and
forming the bonded body by providing an electroless plating solution on the triazine ring and the alkoxysilyl group of the surface B.

21. A bonding agent for use in bonding a metal material and a polymer material B,
wherein a peel strength is 5 N/cm or greater in peeling off at a speed of 50 mm/min in accordance with the method of JIS K6854-1: 1999 "Adhesives-Determination of peel strength of bonded assemblies- Part 1: 90° peel".

22. The bonding agent according to claim 21, wherein the bonding agent has the peel strength of 5 N/cm or greater after a solder reflow test at 260°C.

23. The bonding agent according to claim 21 or 22, wherein the bonding agent is used for bonding a copper foil including copper as the metal material.

24. The bonding agent according to claim 23, wherein a bonding surface of the copper foil has surface roughness (Rz) from 0.5 to 1.5 µm.

25. The bonding agent according to claim 23, wherein a bonding surface of the copper foil has surface roughness (Rz) from 0.5 to 1.0 µm.

26. The bonding agent according to claim 23, wherein a bonding surface of the copper foil has surface roughness (Rz) of 0.8 µm.

27. The bonding agent according to any one of claims 21 to 26, containing a compound (α) represented by general formula (1): 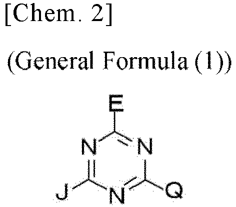 where
J is an organic group including a carbon-carbon double bond,
E is a group including an OH group or an OH-generating group,
Q is an organic group including a carbon-carbon double bond, the organic group being identical to or different from J, or NR₁(R₂),
the R₁ and the R₂ are each H, a hydrocarbon group having from 1 to 24 carbons, or -RSi(R')ₙ₁(OR")₃₋ₙ₁, which may be identical or different,
the R is a linear divalent hydrocarbon group having from 1 to 12 carbons,
the R' is a linear hydrocarbon group having from 1 to 4 carbon atoms,
the R" is H or a linear hydrocarbon group having from 1 to 4 carbons, and
the n1 is an integer from 0 to 2.

28. A bonded body formed by bonding a metal material and a polymer material B with a bonding agent, wherein a peel strength is 5 N/cm or greater in peeling off the metal material or the polymer material at a speed of 50 mm/min in accordance with the method of JIS K6854-1: 1999 "Adhesives-Determination of peel strength of bonded assemblies- Part 1: 90° peel".

29. The bonded body according to claim 28, wherein the bonded body has the peel strength of 5 N/cm or greater after a solder reflow test at 260°C.

30. The bonded body according to claim 28 or 29, wherein the bonded body is formed by bonding a copper foil with copper as the metal material.

31. The bonded body according to claim 30, wherein a bonding surface of the copper foil has surface roughness (Rz) from 0.5 to 1.5 µm.

32. The bonded body according to claim 30, wherein a bonding surface of the copper foil has surface roughness (Rz) from 0.5 to 1.0 µm.

33. The bonded body according to claim 30, wherein a bonding surface of the copper foil has surface roughness (Rz) of 0.8 µm.

34. A printed circuit board comprising the bonded body described in any one of claims 27 to 33.
